# EUROPEAN PATENT APPLICATION

(11) **EP 2 019 314 A1**
(43) Date of publication of application: **28.01.2009**
(21) Application number: 06797385.9
(22) Date of filing: 04.09.2006
(51) Int. Cl.: G01N 27/90

(54) **WAFER SILICON LAYER SCRATCH CHECK DEVICE AND SCRATCH CHECK METHOD**

(30) Priority: 19.05.2006 JP 2006140453
(71) Applicant: Sakaki, Tetsuo, Kawasaki-shi, Kanagawa 215-0004 (JP)
(72) Inventor: SHIRASAKA, Tomohisa, Tokyo 103-8577 (JP); KOBAYASHI, Tsuneo, Fukuoka-shi Fukuoka 814-0001 (JP)
(74) Representative: Regelmann, Thomas
(86) International application number: PCT/JP2006/317462
(87) International publication number: WO 2007/135753

(57) **Abstract**

The present invention is achieved for the purpose of easily detecting a crack or flaw existing in the silicon layer of a wafer in a short period of time. The flaw detector thus provided includes a coil sensor placed at a predetermined distance from the surface of the silicon layer; a radiofrequency applier for applying a radiofrequency to the coil sensor; a scanner for relatively moving the silicon layer and the coil sensor with a constant distance between the surface of the silicon layer and the coil sensor; and a crack detector for detecting a crack or flaw existing in the silicon layer by detecting the change of a signal provided from the coil sensor or the change in the radiofrequency applied by the radiofrequency applier. The frequency of the radiofrequency applied by the radiofrequency applier may be set between 5MHz and 200MHz. This enables a flaw detection for a silicon layer which has been considered to be impossible. In the case where the silicon to be flaw-detected is low resistivity silicon, the frequency applied may be set between 0.5MHz and 200MHz.

## Description

### TECHNICAL FIELD

The present invention relates to an apparatus and method for contactlessly detecting a crack or flaw existing in a silicon layer of a semiconductor wafer. Hereinafter, a semiconductor wafer will be appropriately called "wafer" for short. More precisely, the present invention relates to an apparatus and method for detecting a crack or flaw existing in a silicon layer of a wafer by using an eddy current.

### BACKGROUND ART

A wafer, which serves as a substrate of an IC (integrated circuit), is a disk having a thickness approximately 0.5 to 1.5mm made by slicing an ingot which is a crystalline cylinder of a raw material. The general raw materials used for a wafer are silicon (Si), germanium (Ge), or gallium arsenide (GaAs). In some cases, a multilayer structure in which an oxide film layer or a metal layer is further formed on the disk manufactured as just described is also called a wafer.

In recent decades, elements manufactured in an IC have been constantly getting downsized and more highly integrated. Hence, the purity of a semiconductor wafer is required to be high enough to be used for a highly integrated IC. In the case where the raw material of a wafer is silicon, its purity is elevated as high as 99.999999999 percent (which is called "eleven nines").

In the wafer manufactured with very high purity as previously stated, any physical deficiency is not allowed to exist as a matter of course. For this reason, it is important to perform a flaw detection to check that there are no cracks or flaws. Although the most basic method for flaw detection is a visual check, it is difficult to detect a crack or flaw with this method since the surface of a wafer is mirror-finished. In addition, this method has another disadvantage in that cracks or flaws existing not on the surface of a wafer but inside the wafer cannot be visually detected.

Given this factor, flaw detection for a semiconductor wafer has been optically performed using a laser or the like in order to carry out a precise detection. An example of such a flaw detector is disclosed in Patent Document 1. According to Patent Document 1, it is possible to clearly distinguish between the surface imperfection and internal imperfection by using a polarizing plate, with a detector which detects both a flaw existing on the surface of a semiconductor wafer and a flaw existing inside the wafer using a p-polarized component and an s-polarized component of a laser.

[Patent Document 1] Japanese Unexamined Patent Application Publication No. H11-166902 (Fig. 1)

### DISCLOSURE OF THE INVENTION

### PROBLEM TO BE SOLVED BY THE INVENTION

With the optical flaw detection method for a semiconductor wafer as stated earlier, flaws of a wafer can be detected with a high degree of accuracy. However, this flaw detection method using a laser, which has been conventionally used, has a disadvantage that all the microscopic areas on a wafer's surface are required to be scanned. That is, it takes a very long period of time. With a currently available general flaw detector for a semiconductor wafer, for example, it takes approximately 20 minutes to examine one 8-inch wafer, and approximately as long as 40 minutes for a 12-inch wafer. For this reason, industrially speaking, flaw detection for a wafer can only be performed by a sampling inspection; usually, the existence of a defect in a wafer is ultimately known at a stage after an IC (integrated circuit) is formed and its operation test is performed.

Hence, a method for detecting a crack or flaw existing in a silicon layer of a semiconductor wafer in a short time and with high accuracy has been desired. One of the preferable flaw detection methods having those sorts of features is an eddy current examination. Such flaw detection using an eddy current has, however, a disadvantage in that a flaw detection cannot be accurately performed whenever an object to be examined includes a silicon layer, because the silicon generates a noise. Accordingly, silicon has been considered to be an obstacle to an eddy current examination by those skilled in the art.
With this background, it has been implicitly considered that a semiconductor wafer having a silicon layer cannot be flaw-detected using an eddy current.

The inventors of the present invention thought, however, that the generation of a noise must be evidence of some response by the silicon and have devoted research to discover the silicon's resonance condition. As a result, they have found that the application of a remarkably higher than usual frequency of an electric current to a sensor coil generates an eddy current in silicon, which allows an eddy current examination.

This has enabled the realization of a flaw detector for a silicon layer in a wafer which takes many advantages of an eddy current flaw detector, such as a plain principle, simple configuration of the apparatus, sure flaw detection, quick flaw detection, and noncontact flaw detection.

### MEANS FOR SOLVING THE PROBLEMS

To solve the previously-described problems, the present invention provides a flaw detector for a silicon layer of a wafer, for detecting a crack or flaw existing in an intrinsic silicon layer of a wafer by using an eddy current, including:
a coil sensor placed at a predetermined distance from a surface of the silicon layer;
a radiofrequency applier for applying a radiofrequency of 5MHz through 200MHz to the coil sensor;
a scanner for relatively moving the silicon layer and the coil sensor with a constant distance between the surface of the silicon layer and the coil sensor; and
a crack detector for detecting a crack or flaw existing in the silicon layer by detecting a change of a signal provided from the coil sensor or a change in the radiofrequency applied by the radiofrequency applier.

Another aspect of the flaw detector for a silicon layer of a wafer according to the present invention is a flaw detector for detecting a crack or flaw existing in a low resistivity silicon layer, including:
a coil sensor placed at a predetermined distance from a surface of the silicon layer;
a radiofrequency applier for applying a radiofrequency of 0.5MHz through 200MHz to the coil sensor;
a scanner for relatively moving the silicon layer and the coil sensor with a constant distance between the surface of the silicon layer and the coil sensor; and
a crack detector for detecting a crack or a flaw existing in the silicon layer by detecting a change of a signal provided from the coil sensor or a change in the radiofrequency applied by the radiofrequency applier.

### EFFECT OF THE INVENTION

With the flaw detector for a silicon layer of a wafer according to the present invention, it is possible to detect the existence of a crack or flaw in a silicon layer which is a component of a wafer without taking much time to scan the microscopic areas. In addition, its relatively simple configuration leads to cost efficiency.

In the other aspect of the flaw detector of the present invention, it is possible to very easily perform a flaw detection for a silicon layer as with the aforementioned flaw detector even in the case where cracks and flaws exist in low resistivity silicon.

### BRIEF DESCRIPTION OF THE DRAWINGS

Fig. 1 is a schematic view illustrating the outline of the flaw detector according to the present invention.
Fig. 2 illustrates a configuration example of a crack finder.
Fig. 3 illustrates another configuration example of a crack finder.
Fig. 4 illustrates further another configuration example of a crack finder.
Figs. 5(a) and 5(b) are graphs each illustrating the relationship between the crack output and measurement position in the case where (a) a flaw-free sample or (b) a cracked sample of a wafer composed of normal silicon is used as a target and a radiofrequency of 5MHz is applied to the coil sensor.
Fig. 6 is a graph illustrating the relationship between the crack output and measurement position in the case where a wafer composed of normal silicon is used as a target and a radiofrequency of 200MHz is applied to the coil sensor.
Fig. 7 is a graph illustrating the relationship between the crack output and measurement position in the case where a wafer composed of low resistivity silicon is used as a target and a radiofrequency of 0.5MHz is applied to the coil sensor.
Fig. 8 is a graph illustrating the relationship between the crack output and measurement position in the case where a wafer composed of low resistivity silicon is used as a target and a radiofrequency of 200MHz is applied to the coil sensor.
Fig. 9(a) is a configuration diagram of a scanning method, Fig. 9(b) is a plain view of the scanning method's configuration, Fig. 9(c) is a graph illustrating the relationship between the output signal's frequency and measurement position of a sample without a crack, Fig. 9(d) is a graph illustrating the relationship between the output signal's frequency and measurement position of a sample with a crack, in the case where a wafer composed of normal silicon is used as a target and a radiofrequency of 200MHz is applied to the coil sensor.
Fig. 10 is a cross-sectional view of an example of a silicon solar cell which can be flaw-detected by the flaw detector according to the present invention.
Fig. 11 is a graph illustrating the relationship between the crack output and measurement position in the case where a wafer of a solar cell is used as a target and a radiofrequency of 8MHz is applied to the coil sensor.

### EXPLANATION OF NUMERALS

1. Coil Sensor
2 Radiofrequency Applier
3 Scanner
4 Crack Detector
5 Wafer

### BEST MODES FOR CARRYING OUT THE INVENTION

The flaw detector according to the present invention detects defects such as a crack or flaw existing in a silicon layer of a wafer. As described earlier, there are two types of wafers; one has a single layer structure composed only of a silicon layer, and the other has a multilayer structure composed of a metal layer, an oxide film layer, etc, in addition to a silicon layer. With the flaw detector according to the present invention, both types of wafers' silicon layer can be flaw-detected.Additionally, the flaw detector can detect a crack or flaw in a silicon layer of a wafer in which a wiring pattern or the like is formed on the surface of the silicon layer or other layers. In the present invention, "crack" indicates a breach, and "flaw" indicates all kinds of defects including a nonsmooth part existing on the surface and a contained foreign matter. Hereinafter, "crack or flaw" will be simply and appropriately described "crack" for short.

Silicon which comprises a silicon layer may be single-crystal silicon, polycrystal silicon, or amorphous silicon. In the meantime, there are two types of single-crystal silicon; one is what is called normal silicon (which will be appropriately described "normal silicon" hereinafter) whose resistivity is approximately 10Ω·m and the other is low resistivity silicon whose resistivity is not over 0.1Ω·m. They are separately used according to necessity.

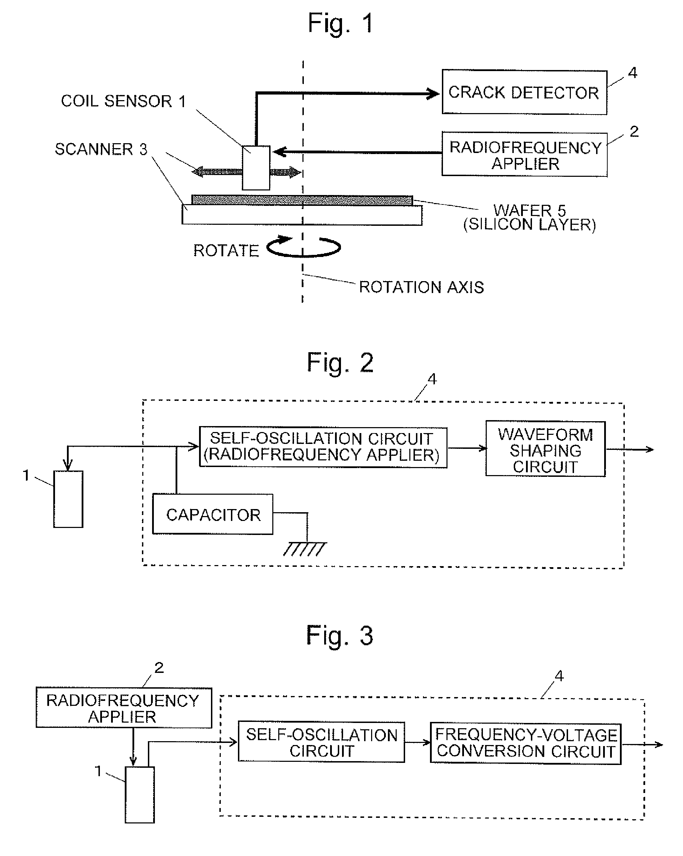

The configuration of the flaw detector according to the present invention will be explained with reference to Fig. 1 which is a schematic view. The fundamental configuration of the flaw detector according to the present invention is composed of a coil sensor 1, a radiofrequency applier 2, a scanner 3, and a crack detector 4.

The coil sensor 1 is an induction coil for an eddy current sensor, and its one end is connected to the radiofrequency applier 2 which will be described later and the other end is connected to the crack detector 4 which will also be described later. The coil sensor 1 is placed at a predetermined distance from the surface of the silicon layer of the wafer 5, i.e. the surface of the wafer 5. The distance between the coil sensor 1 and the surface of the wafer 5 may preferably be, but not limited to, approximately 1mm to 5mm.

The radiofrequency applier 2 is a unit for applying a radiofrequency to the coil sensor 1. Since the target to be flaw-detected is silicon in the present invention, the frequency of the radiofrequency applied to the coil sensor 1 by the radiofrequency applier 2 may be in the range of 5MHz to 200MHz, which is higher than the frequency (in the range of 500KHz to 1MHz) in a normal eddy current flaw detector whose target is metal. The use of a radiofrequency of such frequency generates an eddy current inside the silicon layer of the wafer. In the case where low resistivity silicon is used in the silicon layer of a wafer, the radiofrequency applied to the coil sensor 1 by the radiofrequency applier 2 may preferably be between 0.5MHz and 200MHz.

The crack detector 4 is a unit for detecting the existence of a crack or flaw in the silicon layer of a wafer based on a signal provided from the coil sensor 1. If a crack or flaw exists in a silicon layer, the eddy current's state is changed, which changes the coil's inductance. Accordingly, the voltage value and frequency of the radiofrequency applied from the radiofrequency applier change, and the voltage value and frequency of the output signal provided from the coil sensor change. Hence, by detecting such a change, it is possible to effortlessly perform a flaw detection. Although the configuration of the crack detector 4 is not specifically limited in the present invention, as an example it may be as follows.

### -Detecting the change in the frequency of a signal provided from a coil sensor

In this case, the crack detector 4 may have a circuit configuration as illustrated in Fig. 2 for example so that a radiofrequency is applied to the coil sensor 1 from a self-oscillation circuit which also serves as a radiofrequency applier. In the case where cracks or flaws exist in the wafer's silicon layer, the coil's inductance of the coil sensor 1 changes, which changes the self-oscillation circuit's oscillating frequency. Hence, after the output signal is formed into a square wave in a waveform shaping circuit, a change (turbulence) occurs in the frequency provided from a frequency counter (not shown) or the like. Based on the turbulence, a flaw detection can be performed.

### - Detecting the change of the voltage value of a signal provided from a coil sensor

In the case where cracks or flaws exist in the wafer's silicon layer, the intensity of a magnetic field produced in accordance with an eddy current generated in the silicon layer changes. Accordingly, the voltage value of the signal provided from the coil sensor also changes. By detecting this voltage value's change, it is possible to detect the existence of a crack or flaw. In order to perform this detection, the crack detector 4 may have a circuit configuration as illustrated in Fig. 3 for example. With the configuration illustrated in Fig. 3, an output signal provided from the coil sensor 1 to which a predetermined radiofrequency is applied by the radiofrequency applier 2 is made to pass through a self-oscillation circuit and a frequency-voltage conversion circuit to provide a voltage value. The circuit in the present configuration may be a crystal oscillation circuit.

In the case where the detection of cracks and flaws is performed based on a voltage value, the voltage of the radiofrequency signal in the radiofrequency applier 2 and that of the output signal may be compared.

Since the voltage of the radiofrequency applied from the radiofrequency applier 2 drops due to the existence of a crack or flaw in the silicon layer of a wafer, it is possible to perform a flaw detection by detecting the voltage drop.

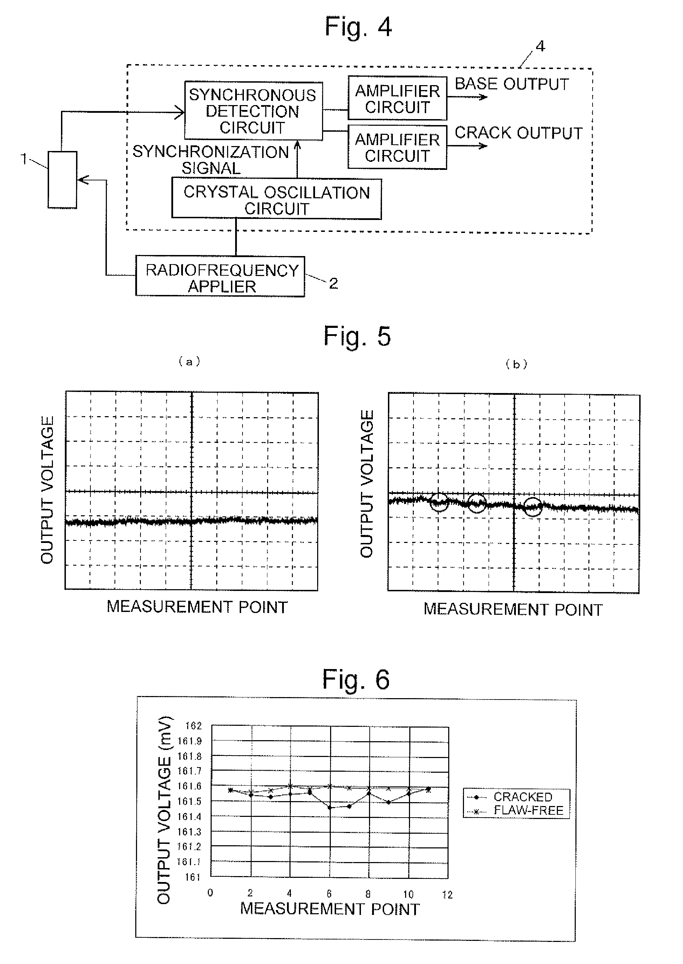

In another further configuration, the crack detector 4 may include a synchronous detection circuit as illustrated in Fig. 4. The example of Fig. 4 includes a crystal oscillation circuit for exciting the coil sensor 1 and for providing a synchronization signal for synchronous detection. The synchronous detection circuit processes the synchronization signal provided from the crystal oscillation circuit and the frequency of the output signal provided from the coil sensor 1 to separately provide a base output (output from the silicon layer itself) and a crack output (output from the existence of a crack or flaw). Between these two types of outputs, the crack output can be used to perform a flaw detection.

In the present invention, the crack detector 4 may include a crack determiner for automatically determining the existence of a crack when a value of various kinds of after-processed or before-processed signals, e.g. the aforementioned crack output, exceeds a predetermined threshold value. Alternatively, the crack detector may simply provide the alteration of the frequency or voltage value to a monitor or the like. In the latter case, an operator visually determines the existence of a crack or flaw based on the waveforms or other information displayed on the monitor.

The scanner 3 keeps the distance constant between the surface of the silicon layer of the wafer and the coil sensor 1 and relatively moves them. In the example of Fig. 1, the scanner 3 is composed of a rotation part on which a disk-shaped wafer 5 can be placed and a parallel moving part. The rotation part rotates on the rotation axis. The parallel moving part moves the coil sensor 1 in the direction of the radial direction of the wafer 5 with a constant distance between the coil sensor 1 and the surface of the silicon layer, i.e. the surface of the wafer 5. If the parallel moving part moves at a constant rate while the rotation part rotates, it is possible to scan the entire area of the wafer 5. The configuration of the scanner 3 may be any type as long as it is possible to scan the entire area of the silicon layer of the wafer 5, and is not limited to the aforementioned configuration.

### EMBODIMENT

Hereinafter, an examination result, performed by the inventors of the present invention, with regard to normal silicon and low resistivity silicon will be described. In this examination, the crack detector 4 had a configuration illustrated in Fig. 2, and the crack output (voltage) was measured.

Fig. 5 is a graph illustrating the relationship between the crack output (voltage) and measurement position in the case where a wafer composed of normal silicon was used as a sample and a radiofrequency of 5MHz was applied to the coil sensor 1. The sample had a single silicon layer having a thickness of 0.2mm, and the resistivity of the silicon was 10Ω·m. The distance between the wafer's surface and the coil sensor was 1mm. Fig. 5(a) is a result of a wafer which was known in advance to be free from a crack or flaw, and Fig. 5(b) is a result of a wafer having a crack. Comparing both sample's results, it is found that although peaks or dips are not observed for the flaw-free wafer, dips indicating the existence of a crack or flaw in the silicon layer appeared for the cracked wafer as indicated by circles in Fig. 5(b). In the case where the frequency was less or equal to 5MHz, the dips and peaks are not clear.

Fig. 6 is a graph illustrating the relationship between the crack output (voltage) and measurement position in the case where the same wafer as described earlier was used as a target and a radiofrequency of 200MHz was applied to the coil sensor 1. As is evident from Fig. 6, clear dips appeared in the crack output's voltage value for the cracked sample.
Meanwhile, it is possible to perform a crack detection even in the case where the frequency is greater than 200MHz. In this case, however, it is not possible to assure the coil diameter of ϕ=20mm which enables a contactless high sensitivity flaw detection in the coil sensor 1. That is, the number of turns of a coil becomes less or equal to one. Therefor, the frequency of the radiofrequency provided by the radiofrequency applier 2 may preferably be between 5MHz to 200MHz for the crack detection for a silicon layer composed of normal silicon.

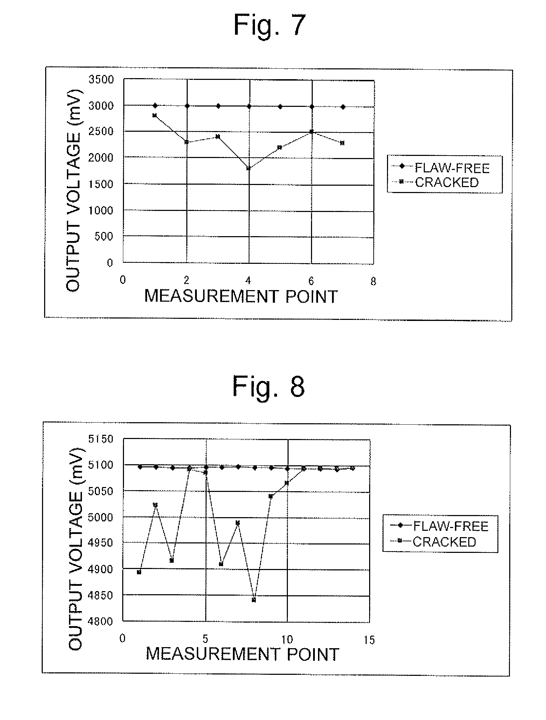

Next, the inventors used a wafer composed of low resistivity silicon as a sample and applied to a radiofrequency (alternating current) of 200MHz to the coil sensor 1. The sample had a single silicon layer having a thickness of 0.2mm, and the resistivity of the silicon was 0.1Ω·m. The distance between the wafer's surface and the coil sensor was 5mm. The relationship between the crack output and the measurement position in this case is illustrated in Fig. 7. The voltage value of the crack output was maintained virtually constant for the flaw-free sample which was known to be free from a crack or flaw. On the contrary, significant turbulences occurred in the crack output for a cracked sample. Fig. 8 is a graph illustrating the relationship between the crack output and the measurement position in the case where the frequency of the radiofrequency signal was 200MHz. As is also evident from the graph of Fig. 8, the waveform showed a significant turbulence for the cracked wafer. In this manner, the flaw detector for the silicon layer of a wafer according to the present invention can definitely perform a flaw detection even in the case where the silicon is made of low resistivity silicon.
Although it is possible to detect a crack even in the case where the frequency is less than 0.5MHz or higher than 200MHz, the number of turns of a coil becomes too small in the coil sensor 1, e.g. the number of turns becomes less or equal to one. Hence, the frequency of the radiofrequency may preferably be between 0.5MHz and 200MHz in order to perform a crack detection for a silicon layer composed of low resistivity silicon.

In the aforementioned experiment example, the speed of rotation of the sample by the scanner was 4rpm; however, the scanner can operate in practice with the speed of rotation approximately 120rpm. Since a general coil sensor 1 can perform a flaw detection with a diameter approximately 10mm, the time required to perform a flaw detection for a wafer having a diameter of 300mm is 150/10×0.5=7.5 seconds, where the wafer's radius is 150mm and the time required for a rotation is 0.5 seconds. This shows that the flaw detector according to the present invention can perform a flaw detection incomparably faster than conventional flaw detectors for a wafer.

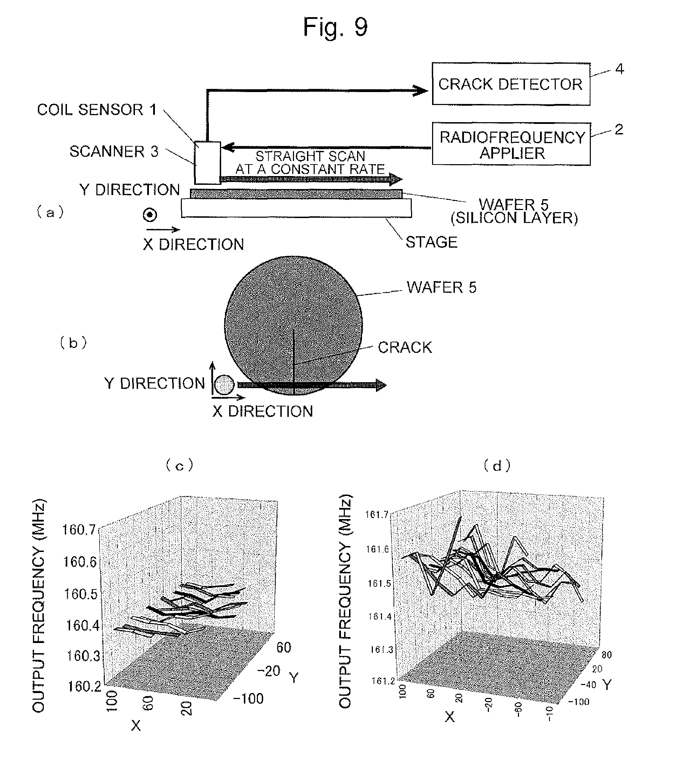

Furthermore, the inventors performed a flaw detection by measuring the output signal's frequency. In this experiment, the wafer 5 was placed still on the stage without being rotated. While the scanner 3 was straightly scanning in the X-direction at a constant rate (refer to Figs. 9(a) and 9(b)), the output frequency at each point of the wafer 5 was recorded. The frequency of 200MHz was applied to the coil sensor 1.

Fig. 9(c) is a graph of the output frequency of a wafer which was known to be free from any crack or flaw, and Fig. 9(d) is a graph of the output frequency of a cracked wafer. In the case where there is no crack, the output signal's frequency remained constant to some extent. On the other hand, in the case where there was a crack, significant turbulences of the frequency of the output signal was observed, which confirmed that the crack detection is substantially possible.

As just described, the flaw detector for a silicon layer of a wafer according to the present invention was explained. The embodiments described thus far are mere examples, and it is evident that any change or modification can be properly made within the sprit of the present invention.

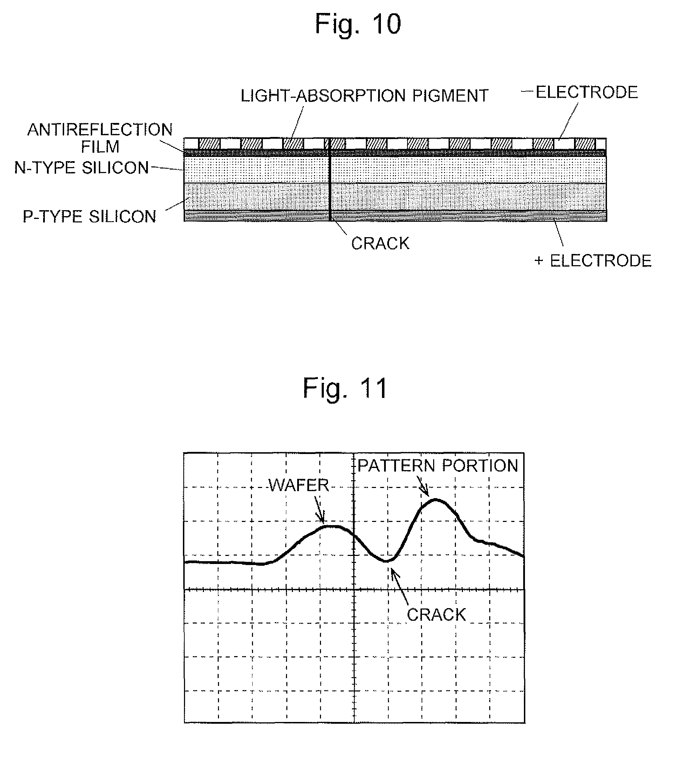

The target of the flaw detection by the flaw detector and flaw detection method according to the present invention is not limited to a silicon wafer used for an IC substrate. Various kinds of wafers can be targeted and cracks or flaws existing in the silicon layer can be detected. For example, a wafer used for a silicon solar cell having a cross section as illustrated in Fig. 10 can be targeted for flaw detection.

A flaw detection experiment was performed in which a solar cell of 1mm in thickness was used as a target, as illustrated in Fig. 10. The target had a negative electrode and a light-absorption pigment on its surface layer and had n-type and p-type silicon (polycrystal silicon) layers in addition to an antireflection film between the surface layer and a positive electrode layer as a bottom layer. This solar cell was placed on a turntable composed of an insulator (ceramic) and a glass plate placed thereon. A radiofrequency of 8MHz was applied to the coil sensor 1 while turning the turntable at the speed of rotation of 4rpm. Fig. 11 illustrates a graph showing the relationship between the output voltage (vertical axis) and the measurement position (horizontal axis) in this case. As illustrated in the graph of Fig. 11, the output's direction is opposite (i.e. a peak or dip) between the flaw-free portion and a pattern-formed (silver paste) portion, and a cracked portion. This indicates that, even in the case where a solar cell having a pattern on the surface of a wafer is targeted, it is possible to perform a flaw detection for a silicon layer by the flaw detector and the flaw detection method according to the present invention.

## Claims

1. A flaw detector for a silicon layer of a wafer, for detecting a crack or flaw existing in an intrinsic silicon layer of a wafer by using an eddy current, comprising:
a coil sensor placed at a predetermined distance from a surface of the silicon layer;
a radiofrequency applier for applying a radiofrequency of 5MHz through 200MHz to the coil sensor;
a scanner for relatively moving the silicon layer and the coil sensor with a constant distance between the surface of the silicon layer and the coil sensor; and
a crack detector for detecting a crack or flaw existing in the silicon layer by detecting a change of a signal provided from the coil sensor or a change in the radiofrequency applied by the radiofrequency applier.

2. A flaw detector for a silicon layer of a wafer, for detecting a crack or flaw existing in a low resistivity silicon layer of a wafer by using an eddy current, comprising:
a coil sensor placed at a predetermined distance from a surface of the silicon layer;
a radiofrequency applier for applying a radiofrequency of 0.5MHz through 200MHz to the coil sensor;
a scanner for relatively moving the silicon layer and the coil sensor with a constant distance between the surface of the silicon layer and the coil sensor; and
a crack detector for detecting a crack or flaw existing in the silicon layer by detecting a change of a signal provided from the coil sensor or a change in the radiofrequency applied by the radiofrequency applier.

3. The flaw detector for a silicon layer of a wafer according to either claim 1 or 2, wherein the crack detector detects a crack or flaw existing in the silicon layer based on a change in a signal frequency provided from the coil sensor or a change in a frequency of the radiofrequency applied by the radiofrequency applier.

4. The flaw detector for a silicon layer of a wafer according to either claim 1 or 2, wherein the crack detector detects a crack or flaw existing in the silicon layer based on a change of a voltage value of the signal provided from the coil sensor or a change of a voltage value of the radiofrequency applied by the radiofrequency applier.

5. The flaw detector for a silicon layer of a wafer according to any one of claims 1 through 4, wherein the silicon layer is made of single-crystal silicon or polycrystal silicon.

6. The flaw detector for a silicon layer of a wafer according to any one of claims 1 through 5, wherein the wafer is a wafer of a silicon solar cell.

7. A flaw detection method for a silicon layer of a wafer, for detecting a crack or flaw existing in an intrinsic silicon layer of a wafer, comprising:
applying a radiofrequency of 5MHz through 200MHz to a coil sensor placed at a predetermined distance from a surface of the silicon layer to generate an eddy current in the silicon layer;
relatively moving the silicon layer and the coil sensor with a constant distance between the surface of the silicon layer and the coil sensor; and
detecting a crack or flaw existing in the silicon layer by detecting a change of a signal provided from the coil sensor or a change in the radiofrequency applied by the radiofrequency applier.

8. A flaw detection method for a silicon layer of a wafer, for detecting a crack or flaw existing in a low resistivity silicon layer of a wafer, comprising:
applying a radiofrequency of 0.5MHz through 200MHz to a coil sensor placed at a predetermined distance from a surface of the silicon layer to generate an eddy current in the silicon layer;
relatively moving the silicon layer and the coil sensor with a constant distance between the surface of the silicon layer and the coil sensor; and
detecting a crack or flaw existing in the silicon layer by detecting a change of a signal provided from the coil sensor or a change in the radiofrequency applied by the radiofrequency applier.

9. The flaw detection method for a silicon layer of a wafer according to either claim 7 or 8, wherein the silicon layer is made of single-crystal silicon or polycrystal silicon.

10. The flaw detection method for a silicon layer of a wafer according to any one of claims 7 through 9, wherein the wafer is a wafer of a silicon solar cell.
